(19) **Europäisches Patentamt / European Patent Office / Office européen des brevets**

(11) **EP 1 993 144 A1**

(12) # EUROPEAN PATENT APPLICATION
published in accordance with Art. 158(3) EPC

(43) Date of publication:
**19.11.2008 Bulletin 2008/47**

(51) Int Cl.:
***H01L 31/04*** *(2006.01)* ***H01L 21/288*** *(2006.01)*

(21) Application number: **07713769.3**

(22) Date of filing: **02.02.2007**

(86) International application number:
**PCT/JP2007/051769**

(87) International publication number:
**WO 2007/102287 (13.09.2007 Gazette 2007/37)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **07.03.2006 JP 2006060531**
**31.08.2006 JP 2006235524**

(71) Applicant: **Murata Manufacturing Co. Ltd.**
**Nagaokakyo-shi, Kyoto 617-8555 (JP)**

(72) Inventor: **KAWAGUCHI, Yoshihiro**
**Nagaokakyo-shi**
**Kyoto 617-8555 (JP)**

(74) Representative: **Laufhütte, Dieter et al**
**Lorenz-Seidler-Gossel**
**Widenmayerstrasse 23**
**80538 München (DE)**

(54) **CONDUCTIVE PASTE AND SOLAR CELL**

(57)     An electrically conductive paste is provided, which can be formed into an electrode by being fired at relatively low temperatures, which exhibits excellent adhesion strength between a light-receiving surface electrode and a semiconductor substrate, and which can satisfactorily reduce the contact resistance between the two.

An electrically conductive paste used as a material for a light-receiving surface electrode of a solar cell, the electrically conductive paste including a Ag powder, an organic vehicle, and glass frit, wherein the softening point of the above-described glass frit is 570°C or higher, and 760°C or lower, and the glass frit contains $B_2O_3$ and $SiO_2$ in such a way that a ratio, $B_2O_3/SiO_2$, becomes 0.3 or less on a molar ratio basis and contains 0 to less than 20.0 percent by mole of $Bi_2O_3$.

FIG. 1

**EP 1 993 144 A1**

**Description**

Technical Field

The present invention relates to an electrically conductive paste serving as an electrically conductive material used for a light-receiving surface electrode of a solar cell. In particular, the present invention relates to an electrically conductive paste containing a Ag powder and silicate glass based glass frit and a solar cell provided with a light-receiving surface electrode by using the electrically conductive paste.

Background Art

In a solar cell including a Si semiconductor, a semiconductor substrate provided with an n-type Si based semiconductor layer on an upper surface of a p-type Si based semiconductor layer has been used previously. A light-receiving surface electrode is disposed on one surface of this semiconductor substrate, and a reverse surface electrode is disposed on the other surface.

The light-receiving surface electrode is previously formed by baking an electrically conductive paste containing a metal powder. As for such an electrically conductive paste, for example, an electrically conductive paste containing a Ag powder, glass frit, and an organic vehicle is disclosed in Patent Document 1 described below.

The glass frit has the property of enhancing adhesion strength between the light-receiving surface electrode obtained by firing the electrically conductive paste and the semiconductor substrate. It is believed to be preferable that a glass powder having a low softening point is used as the glass frit in order to obtain high adhesion strength. Patent Document 1 discloses that B-Pb-O based, B-Si-Pb-O based, B-Si-Bi-Pb-O based, or B-Si-Zn-O based glass frit or the like can be appropriately used as such a glass powder. The specific examples thereof show examples in which Pb-B-Si-O based glass frit and B-Si-Zn-O based glass frit are used.

Patent Document 1: Japanese Unexamined Patent Application Publication No. 2001-118425

Disclosure of Invention

Glass frit containing Pb has a relatively low melting point. Therefore, even when firing is conducted by heating at low temperatures, the adhesion strength between a semiconductor substrate and a light-receiving surface electrode can be enhanced effectively. However, since Pb is a hazardous substance, it has been required that a material alternative thereto is used.

As for the glass frit, Patent Document 1 describes B-Si-Zn-O based glass frit besides Pb-B-Si-O based glass frit containing Pb, as described above. However, the description related to the B-Si-Zn-O based glass frit in Patent Document 1 is merely that described above, and any specific composition of this glass frit is not shown.

In the case where a light-receiving surface electrode of a solar cell is formed by using an electrically conductive paste, as described above, an electrically conductive paste which can satisfactorily enhance the adhesion strength between a semiconductor electrode and a light-receiving surface electrode even when firing is conducted at relatively low temperatures and which does not contain a hazardous material, e.g., Pb, has been required intensely.

In consideration of the present circumstances of the above-described related art, it is an object of the present invention to provide an electrically conductive paste which can effectively enhance the adhesion strength between a light-receiving surface electrode and a semiconductor substrate and furthermore reduce the contact resistance between the two even when firing is conducted at relatively low temperatures and which does not contain Pb hazardous to the environment and a solar cell in which a light-receiving surface electrode is provided by using the electrically conductive paste.

According to a first invention of the present invention, an electrically conductive paste used as a material for a light-receiving surface electrode of a solar cell is provided, the electrically conductive paste being characterized by including a Ag powder, an organic vehicle, and glass frit, wherein the softening point of the above-described glass frit is 570°C or higher, and 760°C or lower, and the glass frit contains $B_2O_3$ and $SiO_2$ in such a way that a ratio, $B_2O_3/SiO_2$, becomes 0.3 or less on a molar ratio basis and does not contain $Bi_2O_3$.

According to a second invention of the present invention, an electrically conductive paste used as a material for a light-receiving surface electrode of a solar cell is provided, the electrically conductive paste being characterized by including a Ag powder, an organic vehicle, and glass frit, wherein the softening point of the above-described glass frit is 570°C or higher, and 760°C or lower, and the glass frit contains $B_2O_3$ and $SiO_2$ in such a way that a ratio, $B_2O_3/SiO_2$, becomes 0.3 or less on a molar ratio basis and contains less than 20.0 percent by mole of $Bi_2O_3$.

That is, the present invention (hereafter, the first invention and the second invention are appropriately collectively called the present invention) is characterized in that the Ag powder, the organic vehicle, and the glass frit are included, the softening point of the glass frit is within the range of 570°C to 760°C, and the glass frit contains $SiO_2$ and, if necessary, contains $Bi_2O_3$, and the ratio, $B_2O_3/SiO_2$, is specified to be 0.3 or less on a molar ratio basis.

Preferably, the above-described glass frit further contains $Al_2O_3$, $TiO_2$, and CuO at ratios of $Al_2O_3$ of 15 percent by mole or less, $TiO_2$ of 0 to 10 percent by mole or less, and CuO of 0 to 15 percent by mole or less.

In another specific aspect of the electrically conductive paste according to the present invention, at least one type of additive selected from ZnO, $TiO_2$, and $ZrO_2$ is further included besides the above-described glass frit.

In another specific aspect of the electrically conductive paste according to the present invention, at least one type of metal selected from Zn, Bi, and Ti or a metal compound of the metal in the form of a resinate is further included as an additive besides the above-described glass frit.

A solar cell according to the present invention is characterized by including a semiconductor substrate, a light-receiving surface electrode disposed on one surface of the semiconductor substrate, and a reverse surface electrode disposed on the other surface, wherein the above-described light-receiving surface electrode is composed of an electrically conductive film formed from the electrically conductive paste constructed according to the present invention.

(Advantages)

In the electrically conductive paste according to the first invention, the Ag powder is used as an electrically conductive metal powder, and the glass frit having a softening point of 570°C or higher, and 760°C or lower is used as the glass frit. Furthermore, the glass frit contains $B_2O_3$ and $SiO_2$ in such a way that a ratio, $B_2O_3/SiO_2$, becomes 0.3 or less on a molar ratio basis and does not contain $Bi_2O_3$. Therefore, as is clear from an embodiment according to the present invention described later, even when firing is conducted at relatively low temperatures, a light-receiving surface electrode exhibiting excellent adhesion strength can be formed, and the contact resistance between the light-receiving surface electrode and the semiconductor layer is not increased significantly. In addition, since the glass frit does not contain Pb hazardous to the environment, an electrically conductive paste exhibiting excellent environment resistance can be provided.

In the electrically conductive paste according to the second invention, the Ag powder is included as an electrically conductive metal powder, the softening point of the glass frit is within the range of 570°C to 760°C, and the glass frit having a softening point of 570°C or higher, and 760°C or lower is used as the glass frit. Furthermore, the glass frit contains $B_2O_3$ and $SiO_2$ in such a way that $B_2O_3/SiO_2$ becomes 0.3 or less on a molar ratio basis and contains $Bi_2O_3$ at a ratio of less than 20.0 percent by mole. Therefore, as is clear from examples described later, firing can be conducted at low temperatures, and in the case where a light-receiving surface electrode is formed, the adhesion strength of the light-receiving surface electrode to a semiconductor layer can be enhanced effectively and the contact resistance between the two is not allowed to increase significantly. In addition, the glass frit does not contain Pb hazardous to the environment. Consequently, a solar cell exhibiting excellent reliability and excellent environment resistance characteristic can be provided.

The solar cell according to the present invention has the light-receiving surface electrode on one surface of the semiconductor substrate, and the reverse surface electrode on the other surface, wherein the light-receiving surface electrode is composed of an electrically conductive film formed by baking the electrically conductive paste according to the present invention. Therefore, the light-receiving surface electrode can be formed by baking at relatively low temperatures. Furthermore, the adhesion strength of the light-receiving surface electrode to the semiconductor substrate is allowed to become at a satisfactory level. Moreover, the contact resistance at the interface between the two is not allowed to increase significantly. Consequently, it becomes possible to increase the reliability of the solar cell and reduce the cost. In addition, since the glass frit does not contain Pb, an environmental load can be reduced.

Brief Description of Drawings

[Fig. 1] Fig. 1 is a partial cutaway front sectional view showing a solar cell according to an embodiment of the present invention.

[Fig. 2] Fig. 2 is a magnified partial plan view schematically showing two-dimensional shape of a light-receiving surface electrode of the solar cell, as shown in Fig. 1.

[Fig. 3] Fig. 3 is a schematic plan view showing a screen printing pattern used in formation of light-receiving surface electrodes in Examples and Comparative examples and a plurality of print portions included in the pattern.

Reference Numerals

1    solar cell
2    semiconductor substrate
2a   p-type Si based semiconductor layer
2b   n-type Si based semiconductor layer
3    light-receiving surface electrode
4    antireflection film
5    reverse surface electrode
6    terminal electrode

Best Modes for Carrying Out the Invention

The present invention will be made clear below by describing specific embodiments of the present invention with reference to the drawings.

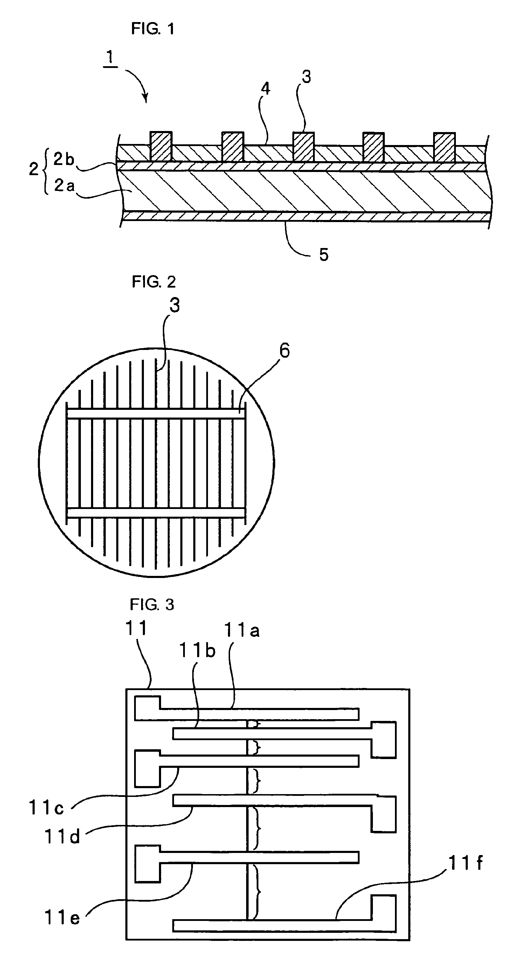

Fig. 1 is a partial cutaway front sectional view showing a solar cell according to an embodiment of the present invention. Fig. 2 is a magnified partial plan view schematically showing an electrode structure disposed on an upper surface thereof.

A solar cell 1 includes a semiconductor substrate 2. The semiconductor substrate 2 has a structure in which an n-type Si based semiconductor layer 2b is disposed on an upper surface of a p-type Si based semiconductor layer 2a. Such a semiconductor substrate 2 is obtained by diffusing impurities in one surface of a p-type Si based semiconductor substrate so as to form the n-type semiconductor layer 2b. However, regarding the semiconductor substrate 2, the structure and the production method thereof are not specifically limited insofar as the n-type Si based semiconductor layer 2b is disposed on the upper surface of the p-type Si based semiconductor layer 2a.

A light-receiving surface electrode 3 is disposed on the side of the surface, on which the n-type Si based semiconductor layer 2b is disposed, that is, the upper surface, of the semiconductor substrate 2. As is clear from the plan view shown in Fig. 2, the light-receiving surface electrode 3 has a structure in which a plurality of stripe-shaped electrode portions are disposed in parallel. Incidentally, one end of the light-receiving surface electrode is electrically connected to a terminal electrode 6. An antireflection film 4 is disposed in regions except the parts on which the light-receiving surface electrode 3 and the terminal electrode 6 are disposed.

On the other hand, a reverse surface electrode 5 is disposed on all over the surface on the lower surface side of the semiconductor substrate 2.

In the solar cell 1, the light-receiving surface electrode 3 is formed by applying and firing an electrically conductive paste according to an embodiment of the present invention. The electrically conductive paste and the light-receiving surface electrode 3 will be described in detail later.

The antireflection film 4 is formed from an appropriate insulating material, e.g., SiN, and is disposed to reduce reflection of light from the outside on the light-receiving surface side and promptly efficiently lead the light to the semiconductor layer 2. The material for constituting this antireflection film 4 is not limited to SiN, and other insulating materials, e.g., $SiO_2$ or $TiO_2$, may be used.

Furthermore, the reverse surface electrode 5 is disposed to take out an electric power between the light-receiving surface electrode 3 and the reverse surface electrode 5. The material for forming this reverse surface electrode 5 is not specifically limited, and the reverse surface electrode 5 is obtained by applying and firing the same electrically conductive paste as that for the light-receiving surface electrode 3 or providing other electrode materials by appropriate methods.

The solar cell 1 is characterized in that the light-receiving surface electrode 3 includes a Ag powder, an organic vehicle, and glass frit, wherein the softening point of the glass frit is within the range of 570°C or higher, and 760°C or lower, and the glass frit has a composition in which a ratio, $B_2O_3/SiO_2$, becomes 0.3 or less on a molar ratio basis.

The Ag powder exhibits good electrical conductivity even in the case where firing is conducted in the air. Therefore, in the present invention, the Ag powder is used as the electrically conductive metal powder of the electrically conductive paste. This Ag powder may be in the shape of a sphere or in the shape of a scale, and the shape thereof is not specifically limited. Furthermore, Ag powders in the shapes of a plurality of types may be used in combination.

The average particle diameter of the Ag powder is not specifically limited. However, 0.1 to 15 $\mu$m is preferable. If the average particle diameter exceeds 15 $\mu$m, contact between the light-receiving surface electrode and the semiconductor substrate tends to become unsatisfactory.

The glass frit contained in the above-described electrically conductive paste is included in order to enhance the adhesion strength in application and baking of the electrically conductive paste.

Furthermore, the reason is that if the softening point of the glass frit is too low, in the firing of the electrically conductive paste, the viscosity of the glass becomes too low, excess glass is accumulated at the interface between the light-receiving surface electrode and the semiconductor substrate and, as a result, the glass may hinder the contact between the two significantly. On the other hand, if the softening point of the glass frit is too high, in the firing of the electrically conductive paste, the viscosity of the glass is not reduced significantly. Consequently, the antireflection film is not removed satisfactorily, bonding between the light-receiving surface electrode and the semiconductor substrate becomes unsatisfactory, and the adhesion strength between the two may be reduced significantly. Therefore, the softening point of the glass frit is specified to be within the range of 570°C or higher, and 760°C or lower.

Preferably, the lower limit of the softening point is 575°C. If the softening point is 575°C or higher, the contact resistance can be reduced. More preferable upper limit temperature of the softening point is 650°C. If the softening point is specified to be 650°C, the firing is conducted at lower temperatures.

Furthermore, a ratio, $B_2O_3/SiO_2$, is required to become 0.3 or less on a molar ratio basis. Preferably, the ratio is 0.2 or less, and in that case, Ag can be deposited on the semiconductor substrate efficiently.

The reason the above-described molar ratio of $B_2O_3/SiO_2$ is specified to be 0.3 or less is that Ag dissolved in the glass is reduced and deposited on the semiconductor substrate surface easily during a firing step in the formation of a solar cell light-receiving surface electrode. It is believed that the contact between the light-receiving surface electrode and the semiconductor substrate is ensured through Ag deposited. If the above-described molar ratio exceeds 0.3, Ag dissolved in the glass becomes present in the glass stably and, thereby, deposition of Ag on the semiconductor substrate may become difficult.

Regarding the electrically conductive paste according to the present invention, in the electrically conductive paste, $Bi_2O_3$ is not contained in the glass frit or even when $Bi_2O_3$ is contained, the content is within the range of less than 20.0 percent by mole. The reason the $Bi_2O_3$ content is specified to be 0.0 or more, and less than 20.0 percent by mole is that if the $Bi_2O_3$ content becomes 20.0 percent by mole or more, in the firing of the electrically conductive paste, the viscosity of the glass becomes too low, excess glass is accumulated at the interface between the light-receiving surface electrode and the semiconductor substrate and, as a result, the glass may hinder the contact between the two significantly. On the other hand, in the case where 0.0 or more, and less than 20.0 percent by mole of $Bi_2O_3$ is blended, excess glass is difficult to accumulate at the interface between the light-receiving surface electrode and the semiconductor substrate.

Furthermore, it is preferable that the glass frit further contains $Al_2O_3$, $TiO_2$, and $CuO$ at ratios of $Al_2O_3$ of 15 percent by mole or less, $TiO_2$ of 10 percent by mole or less, and $CuO$ of 15 percent by mole or less. By $Al_2O_3$, $TiO_2$, and $CuO$ being blended at amounts within the above-described ranges, devitrification of the glass frit is reduced and, in addition, the water resistance of the glass frit itself can be enhanced. If the water resistance of the glass frit is enhanced, the moisture resistance of the electrode film is also enhanced when the electrically conductive paste is hardened.

Regarding the electrically conductive paste according to the present invention, besides the above-described Ag powder, the organic vehicle, and the glass frit, appropriate additives may be further blended. Examples of such additives can include various inorganic powders. Examples of such inorganic powders can include inorganic oxides, e.g., $ZnO$, $TiO_2$, $Ag_2O$, $WO_3$, $V_2O_5$, $Bi_2O_3$, and $ZrO_2$. In the firing of the electrically conductive paste, these inorganic oxides operates to facilitate decomposition of the antireflection film formed on the semiconductor substrate surface in advance and reduce the contact resistance between the light-receiving surface electrode and the semiconductor substrate. It is believed that in the firing of the electrically conductive paste to form the light-receiving surface electrode, the Ag powder also operates as a catalyst for decomposing the antireflection film. In the case where a composition composed of the Ag powder, the organic vehicle, and the glass frit is used, removal of the antireflection film may become unsatisfactory. However, addition of the above-described inorganic oxide is desirable because the catalytic action of Ag is facilitated. Addition of $ZnO$, $TiO_2$, or $ZrO_2$, among the above-described inorganic oxides, is desirable because a higher effect of removing the antireflection film is exhibited. The average particle diameter of the additive composed of these inorganic oxides is not specifically limited. However, 1.0 $\mu$m or less is desirable. Addition of fine powders of such inorganic oxides enhances an catalytic action of Ag more effectively and can reduce the contact resistance between the light-receiving surface electrode and the semiconductor substrate more reliably and stably.

As for such additives, resonates containing metals or metal compounds may be used. As for the metal used for the resinate, at least one metal selected from Zn, Bi, and Ti or a metal compound thereof can be used. Addition of the metal or the metal compound in the form of the resinate into the electrically conductive paste can disperse the metal component more homogeneously as compared with that in the case where addition is conducted in the form of an inorganic powder and, therefore, the antireflection film can be decomposed more effectively. Furthermore, an electrically conductive paste is obtained, in which aggregates resulting from poor dispersion occurred in the paste are made finer and reduced. The use of the resulting electrically conductive paste can form a good printed film which does not easily cause plugging with respect to even a high mesh screen. Moreover, since sintering of the light-receiving surface electrode is not hindered, the light-receiving surface electrode can be densely fired, and the line resistance of the electrode can be reduced.

As for the above-described organic vehicle, an organic resin binder commonly used as an electrically conductive paste for forming the light-receiving surface electrode can be used. Examples of synthetic resins constituting such an organic resin binder can include ethyl cellulose and nitrocellulose.

The electrically conductive paste is prepared by mixing the above-described Ag powder and the glass frit, dispersing the mixture into an organic vehicle solution in which an organic binder resin serving as an organic vehicle is dissolved in a solvent, and conducting kneading. Alternatively, the Ag powder, the organic vehicle, and the glass frit may be put into a solvent which dissolves the organic vehicle, and kneading may be conducted.

The blend ratios of individual components of the electrically conductive paste according to the present invention are not specifically limited. However, it is preferable that the ratio of the above-described glass frit is 1 to 3 parts by weight relative to 100 parts by weight of Ag powder. If the blend ratio of the glass frit is too large, the electrical conductivity becomes unsatisfactory. If the blend ratio of the glass frit is too small, the adhesion strength between the light-receiving surface electrode and the semiconductor substrate is not easily enhanced. The lower limit of the blend ratio of the above-described glass frit is preferably 1.5 parts by weight. The adhesion strength can be further enhanced by specifying the blend ratio to be 1.5 parts by weight or more. Furthermore, the preferable upper limit of the blend ratio of the above-described glass frit is 2.5 parts by weight. The contact resistance can be reduced by specifying the blend ratio to be 2.5 parts by weight or less.

The above-described organic vehicle is blended preferably at a ratio of about 20 parts by weight to 25 parts by weight relative to 100 parts by weight of Ag powder, although not specifically limited. If the blend ratio of the organic vehicle is too large, conversion to a paste may become difficult, and if too low, it may become difficult to ensure a fine line property.

The blend ratio of the additive composed of the above-described inorganic oxide is not specifically limited. However, about 3 to 15 parts by weight relative to 100 parts by weight of Ag powder is desirable. If the blend ratio is less than 3 parts by weight, an effect of addition of the inorganic oxide may not be exerted satisfactorily. If the blend ratio exceeds 15 parts by weight, sintering of the Ag powder may be hindered and the line resistance may increase significantly.

The blend ratio of the above-described additive composed of the resinate is not specifically limited. However, about 8 to 16 parts by weight relative to 100 parts by weight of Ag powder is desirable. Most preferably, the blend ratios of the Zn resinate, the Ti resinate, and the Bi resinate are specified to be 8 parts by weight, 14 parts by weight, and 15 parts by weight, respectively.

As is clear from specific examples described later, the use of the electrically conductive paste containing the glass frit having the above-described specific composition can enhance the adhesion strength of the light-receiving surface electrode 3 to the semiconductor substrate 2 effectively and does not cause significant increase in electrical resistance at contact interface between the two. Consequently, even in the case where firing is conducted at low temperatures, the light-receiving surface electrode 3 exhibiting excellent reliability can be formed and, in addition, reduction in cost of the solar cell and improvement of the reliability can be achieved. Furthermore, since the glass frit does not contain Pb, the environmental load can be reduced.

Next, the present invention will be made clear by describing specific examples and comparative examples.

Regarding an electrically conductive paste, a plurality of types of electrically conductive pastes were prepared, in which 2.2 parts by weight of glass frit having a composition shown in Table 1 and 5 parts by weight of ZnO relative to 100 parts by weight of spherical Ag powder having an average particle diameter of 1 μm were mixed and, furthermore, 3.8 parts by weight of ethyl cellulose serving as a binder resin and terpineol serving as a solvent were contained. Subsequently, the above-described electrically conductive paste was screen-printed on a light-receiving surface, on which a SiN antireflection film was formed entirely, of a polycrystalline silicon solar cell by using a pattern as shown in Fig. 3. In the pattern 11 shown in Fig. 3, print portions 11a to 11f indicate regions in which the electrically conductive paste is printed.

The distance between the print portions 11a and 11b was specified to be 200 μm, the distance between the print portions 11b and 11c was specified to be 400 μm, the distance between the print portions 11c and 11d was specified to be 600 μm, the distance between the print portions 11d and 11e was specified to be 800 μm, and the distance between the print portions 11e and 11f was specified to be 1,000 μm. Here, this distance between the print portions was specified to be the distance between an end edge of one print portion on the side of an end edge of the other print portion and the end edge of the other print portion on the side of the end edge of the one print portion.

After the above-described electrically conductive paste was printed, the electrically conductive paste was dried in an oven set at 150°C. Thereafter, the electrically conductive paste was fired in a near infrared furnace, in which carrying from an inlet to an outlet was conducted in a time of about 4 minutes, on the basis of a firing profile, in which a peak temperature was specified to be 750°C, so as to form a light-receiving surface electrode.

A cell for a solar cell provided with the light-receiving surface electrode as described above was used, and the contact resistance Rc was measured by a TLM (Transmission Line Model) method. This TLM method refers to a method in which the distances and the resistance values between light-receiving surface electrode portions formed in accordance with the print portions shown in Fig. 3 are measured, the relationship of the distance L between the electrode portions with the measured resistance value R is evaluated under various conditions because the relationship represented by the following Formula (1) holds between the distance L between the electrode portions and the measured resistance value R, and the contact resistance Rc is determined by extrapolating L to zero.

$$R = (L/Z) \times RSH + 2Rc \qquad \text{Formula (1)}$$

In Formula (1), R represents a measured resistance value, L represents a distance between the above-described electrode portions, RSH represents a sheet resistance of an n-type Si based semiconductor layer, Z represents a length of the light-receiving surface electrode, that is, a dimension corresponding to the length of the print portion shown in Fig. 3, and Rc represents a contact resistance.

The contact resistance Rc determined as described above is shown in the following Table 1.

In order to form a Ag electrode having the film thickness of 10 $\mu$m and the dimensions of a rectangle of 2 x 3 mm, the above-described electrically conductive paste was screen-printed on a light-receiving surface, on which a SiN antireflection film was formed, of a polycrystalline silicon solar cell. Subsequently, drying was conducted in an oven set at 150°C. Thereafter, firing was conducted by using a near infrared furnace on the basis of a firing profile, in which it took about 4 minutes to pass between an inlet and an outlet and a peak temperature was set at 780°C, so as to form the above-described light-receiving surface electrode. Then, a copper wire was soldered to the light-receiving surface electrode surface so as to obtain a sample. Solder having a composition of Sn-Pb-1.5Ag was used as the solder, and soldering was conducted by dipping in the molten solder at 260°C for 5 seconds.

An external force was applied in a direction of this copper wire being moved away from the solar cell substrate with a tensile tester. The peeling strength at the point in time when the light-receiving surface electrode was peeled off the semiconductor substrate of the solar cell was determined and was assumed to be the adhesion strength of the electrode to the semiconductor substrate. The results are shown in Table 1 described below.

The adhesion strength is evaluated because if the adhesion strength of the light-receiving surface electrode to the semiconductor substrate is low, the light-receiving surface electrode may be peeled off the semiconductor substrate in wiring of an inner lead for mutually connecting semiconductor substrates of the solar cell or in the case where a module is prepared thereafter. Therefore, as the adhesion strength becomes higher, such peeling can be prevented and the reliability can be enhanced.

[Table 1]

| | Glass composition (mol%) | | | | | | | | | | | | | B$_2$O$_3$/SiO$_2$ (mol% ratio) | Ts/ °C | Rc/ Ω | Adhesion strength N/6 mm$^2$ |
|---|---|---|---|---|---|---|---|---|---|---|---|---|---|---|---|---|---|
| | SiO$_2$ | B$_2$O$_3$ | Bi$_2$O$_3$ | Li$_2$O | Na$_2$O | CaO | BaO | ZnO | Al$_2$O$_3$ | TiO$_2$ | ZrO$_2$ | CuO | Total | | | | |
| Example 1 | 54.7 | 12.7 | 13.6 | 0.0 | 0.0 | 0.0 | 18.5 | 0.0 | 5.5 | 4.6 | 0.0 | 2.1 | 100.0 | 0.23 | 611 | 2.6 | 2.4 |
| Example 2 | 49.9 | 14.5 | 0.0 | 0.0 | 0.0 | 4.7 | 22.5 | 1.9 | 2.8 | 1.3 | 2.4 | 0.0 | 100.0 | 0.29 | 754 | 1.3 | 2.0 |
| Example 3 | 49.5 | 4.5 | 18.0 | 0.0 | 0.0 | 0.0 | 18.0 | 0.0 | 9.9 | 0.0 | 0.0 | 0.0 | 100.0 | 0.09 | 614 | 1.8 | 2.7 |
| Example 4 | 52.2 | 13.0 | 17.4 | 0.0 | 0.0 | 0.0 | 17.4 | 0.0 | 0.0 | 0.0 | 0.0 | 0.0 | 100.0 | 0.25 | 597 | 1.8 | 3.6 |
| Example 5 | 43.3 | 11.8 | 19.7 | 0.0 | 0.0 | 0.0 | 15.8 | 0.0 | 9.5 | 0.0 | 0.0 | 0.0 | 100.0 | 0.27 | 575 | 1.9 | 3.4 |
| Example 6 | 51.1 | 12.8 | 17.0 | 0.0 | 0.0 | 0.0 | 17.0 | 0.0 | 0.0 | 2.1 | 0.0 | 0.0 | 100.0 | 0.25 | 605 | 2.1 | 2.6 |
| Example 7 | 56.7 | 15.0 | 13.6 | 0.0 | 0.0 | 0.0 | 0.0 | 0.0 | 10.0 | 4.7 | 0.0 | 0.0 | 100.0 | 0.26 | 611 | 2.6 | 2.5 |
| Example 8 | 47.1 | 13.7 | 5.7 | 0.0 | 0.0 | 4.4 | 21.2 | 1.8 | 2.6 | 1.2 | 2.3 | 0.0 | 100.0 | 0.29 | 703 | 2.4 | 2.1 |
| Comparative example 1 | 47.6 | 10.8 | 27.2 | 0.0 | 0.0 | 0.0 | 0.0 | 0.0 | 10.0 | 4.4 | 0.0 | 0.0 | 100.0 | 0.23 | 566 | 15.5 | 3.7 |
| Comparative example 2 | 36.8 | 19.4 | 0.0 | 3.5 | 3.9 | 3.6 | 13.4 | 12.9 | 4.4 | 0.8 | 1.3 | 0.0 | 100.0 | 0.53 | 606 | 34.9 | 2.9 |

As is clear from Table 1, in Examples 1 to 8, molar ratios, $B_2O_3/SiO_2$, are within the range of 0.29 or less and the softening points of the glass frit fall within the range of 570°C to 760°C and, therefore, the contact resistance Rc between the light-receiving surface electrode obtained by firing and the semiconductor substrate was a low 1.3 to 2.6 Ω or less. Consequently, it is clear that good ohmic contact is achieved.

Furthermore, the adhesion strength between the light-receiving surface electrode formed from Ag and the semiconductor substrate tends to decrease as the softening point of the glass frit becomes higher. However, even in Example 2 in which the softening point was the highest among those in Examples 1 to 8, the adhesion strength was 2.0 N/6 mm$^2$. Therefore, it is clear that the adhesion strength is at a satisfactory level.

On the other hand, the glass frit having a molar ratio, $B_2O_3/SiO_2$, of 0.23 and a softening point of 566°C was used in Comparative example 1 and the glass frit having the above-described molar ratio of 0.53 and a softening point of 606°C was used in Comparative example 2. Consequently, the contact resistances Rc after firing were very high 15.5 Ω and 34.9 Ω, respectively.

That is, regarding Comparative example 1, it is believed that since the softening point of the glass frit is too low, glass which is an insulating material excessively accumulates at an interface between the light-receiving surface electrode formed from Ag and the semiconductor substrate and, thereby, the contact resistance increases. On the other hand, regarding Comparative example 2, it is believed that since the above-described molar ratio is 0.53 and the Ag powder dissolved in the glass is reduced on the surface of the semiconductor substrate formed from Si so as to become difficult to deposit during firing of the electrically conductive paste, the continuity between the light-receiving surface electrode and the semiconductor substrate is not ensured satisfactorily and, thereby, the contact resistance Rc becomes high.

Incidentally, in many cases where the light-receiving surface electrode of the solar cell is formed by the electrically conductive paste, the contact resistance cannot be satisfactorily stably reduced by merely applying and firing the electrically conductive paste. Consequently, in the actual circumstances, a method in which an acid treatment is conducted to reduce the contact resistance between the light-receiving surface electrode and the semiconductor substrate is adopted previously. In general, HF (hydrofluoric acid) is used for such an acid treatment. It is believed that if the acid treatment is conducted by using hydrofluoric acid, glass and oxides of Si present between the light-receiving surface electrode and the semiconductor substrate are dissolved and good contact between the light-receiving surface electrode and the semiconductor substrate is achieved. However, there is also a possibility that glass is dissolved·removed by HF. If glass and the like are excessively dissolved·removed, the adhesion strength between the light-receiving surface electrode and the semiconductor substrate may be reduced.

On the other hand, as shown in the above-described Examples, if the electrically conductive paste according to the present invention is used, the contact resistance Rc can be reduced satisfactorily without conducting such an acid treatment. Consequently, the above-described problems due to the acid treatment do not occur easily and, in addition, an extra step, that is, the acid treatment step, can be omitted. Therefore, the production steps can be cut back.

**Claims**

1. An electrically conductive paste used as a material for a light-receiving surface electrode of a solar cell, the electrically conductive paste **characterized by** comprising:

   a Ag powder, an organic vehicle, and glass frit,

   wherein the softening point of the glass frit is 570°C or higher, and 760°C or lower, and the glass frit contains $B_2O_3$ and $SiO_2$ in such a way that a ratio, $B_2O_3/SiO_2$, becomes 0.3 or less on a molar ratio basis and does not contain $Bi_2O_3$.

2. An electrically conductive paste used as a material for a light-receiving surface electrode of a solar cell, the electrically conductive paste **characterized by** comprising:

   a Ag powder, an organic vehicle, and glass frit,

   wherein the softening point of the glass frit is 570°C or higher, and 760°C or lower, and the glass frit contains $B_2O_3$ and $SiO_2$ in such a way that a ratio, $B_2O_3/SiO_2$, becomes 0.3 or less on a molar ratio basis and contains less than 20.0 percent by mole of $Bi_2O_3$.

3. The electrically conductive paste according to Claim 1, wherein the glass frit further comprises $Al_2O_3$, $TiO_2$, and CuO at ratios of $Al_2O_3$ of 15 percent by mole or less, $TiO_2$ of 0 to 10 percent by mole or less, and CuO of 0 to 15 percent by mole or less.

4. The electrically conductive paste according to any one of Claims 1 to 3, further comprising at least one type of additive selected from ZnO, $TiO_2$, and $ZrO_2$ besides the glass frit.

5. The electrically conductive paste according to any one of Claims 1 to 4, further comprising at least one type of metal selected from Zn, Bi, and Ti or a metal compound of the metal in the form of a resinate as an additive besides the glass frit.

6. A solar cell **characterized by** comprising a semiconductor substrate, a light-receiving surface electrode disposed on one surface of the semiconductor substrate, and a reverse surface electrode disposed on the other surface, wherein the light-receiving surface electrode is composed of an electrically conductive film formed by baking the electrically conductive paste according to any one of Claims 1 to 5.

FIG. 1

FIG. 2

FIG. 3

<div align="center"><b>INTERNATIONAL SEARCH REPORT</b></div>

| | International application No. |
|---|---|
| | PCT/JP2007/051769 |

**A. CLASSIFICATION OF SUBJECT MATTER**
*H01L31/04*(2006.01)i, *H01L21/288*(2006.01)i

According to International Patent Classification (IPC) or to both national classification and IPC

**B. FIELDS SEARCHED**

Minimum documentation searched (classification system followed by classification symbols)
H01L31/04, H01L21/288, H01B1/22

Documentation searched other than minimum documentation to the extent that such documents are included in the fields searched
Jitsuyo Shinan Koho          1922-1996   Jitsuyo Shinan Toroku Koho   1996-2007
Kokai Jitsuyo Shinan Koho   1971-2007   Toroku Jitsuyo Shinan Koho   1994-2007

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2005-317432 A  (Shoei Chemical Inc.), 10 November, 2005 (10.11.05), Par. Nos. [0019] to [0050] (Family: none) | 1-6 |
| Y | JP 2001-118425 A  (Murata Mfg. Co., Ltd.), 27 April, 2001 (27.04.01), Full text; all drawings (Family: none) | 1-6 |

☐ Further documents are listed in the continuation of Box C.          ☐ See patent family annex.

| * | Special categories of cited documents: |
|---|---|
| "A" | document defining the general state of the art which is not considered   to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 07 May, 2007 (07.05.07) | 15 May, 2007 (15.05.07) |

| Name and mailing address of the ISA/ | Authorized officer |
|---|---|
| Japanese Patent Office | |
| Facsimile No. | Telephone No. |

Form PCT/ISA/210 (second sheet) (April 2005)

**EP 1 993 144 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001118425 A